Europäisches Patentamt

European Patent Office

Office européen des brevets

(19)

(11)  **EP 0 952 587 B1**

(12)  **FASCICULE DE BREVET EUROPEEN**

(45)  Date de publication et mention
de la délivrance du brevet:
**14.05.2003  Bulletin 2003/20**

(51)  Int Cl.⁷: **G11C 7/00**

(21)  Numéro de dépôt: **99410022.0**

(22)  Date de dépôt: **26.03.1999**

(54)  **DRAM à structure rapide**

Schnelle DRAM-Anordnung

Fast DRAM layout

(84)  Etats contractants désignés:
**DE FR GB IT**

(30)  Priorité:  **26.03.1998  FR 9804008**

(43)  Date de publication de la demande:
**27.10.1999  Bulletin 1999/43**

(73)  Titulaire: **STMicroelectronics S.A.**
**92120 Montrouge (FR)**

(72)  Inventeurs:
• **Harrand, Michel**
**38120 Saint Egrève (FR)**

• **Ferrant, Richard**
**38330 Saint Ismier (FR)**

(74)  Mandataire: **de Beaumont, Michel**
**1, rue Champollion**
**38000 Grenoble (FR)**

(56)  Documents cités:
**EP-A- 0 499 256**      **US-A- 4 649 516**
**US-A- 5 226 147**      **US-A- 5 625 594**

## Description

La présente invention concerne les mémoires réalisées sous la forme d'un réseau matriciel de cellules mémoire en circuit intégré. L'invention s'applique plus particulièrement aux mémoires dynamiques (DRAM), c'est-à-dire nécessitant un rafraîchissement périodique des données que contiennent les cellules.

Un circuit de mémoire dynamique comprenant des cellules mémoire organisées en un réseau matriciel ainsi que, pour chaque colonne du réseau matriciel, quatre bascules fonctionnant comme mémoire tampon, est connu de US 5 226 145.

Dans des mémoires dynamiques, le contenu d'une cellule mémoire peut disparaître pour deux raisons. D'une part, avec le temps, le contenu de la cellule disparaît en raison de fuites liées à la structure même de la cellule mémoire comprenant un transistor qui, même bloqué, fuit légèrement. D'autre part, à chaque lecture d'une cellule mémoire, le signal est donné par un partage de charges entre une capacité parasite de ligne de bit et la capacité de stockage de la cellule mémoire. Par ce partage de charges, la valeur de la tension dans la cellule mémoire est réduite par rapport à la valeur contenue initialement.

Les deux effets ci-dessus qui conduisent à une perte d'information dans les cellules mémoire imposent de prendre deux types de précautions.

Tout d'abord, il est nécessaire d'organiser un accès périodique à chacune des cellules mémoire de manière à compenser les fuites de charges au cours du temps.

D'autre part, il est nécessaire de restaurer la valeur initiale de la cellule mémoire à chaque accès en amplifiant l'information de la ligne de bit. L'ensemble de ces deux précautions constitue ce que l'on appelle généralement une opération de rafraîchissement/restauration.

Un inconvénient induit par les opérations de rafraîchissement est que celles-ci nuisent aux performances globales de la mémoire en monopolisant des cycles d'accès à celle-ci.

En considérant, à titre d'exemple particulier, qu'une cellule mémoire a un temps de maintien de son contenu de l'ordre d'une milliseconde, il est nécessaire de rafraîchir chaque cellule toutes les millisecondes. Ce rafraîchissement s'effectue en lisant les cellules. En pratique, on lit toutes les cellules d'une rangée au sein d'un même cycle de sorte à rafraîchir toute la rangée. En supposant une mémoire constituée d'un réseau de 1024 X 1024 cellules, il faut alors prévoir un cycle de rafraîchissement toutes les microsecondes. Si le temps d'accès à une cellule est de l'ordre de 100 nanosecondes, 10% des performances de la mémoire sont perdues pour les rafraîchissements.

Une première solution connue pour résoudre ce type de problème est d'accroître le temps de rétention au sein des cellules mémoire. Cette solution n'est toutefois pas facile à mettre en oeuvre et est liée au processus de fabrication des mémoires. De plus, elle ne fait que repousser le problème d'un facteur d'échelle.

Une deuxième solution classique est de partager la mémoire en deux zones travaillant alternativement. A chaque nouvelle adresse de lecture ou d'écriture, on change de mémoire, l'autre mémoire étant alors disponible pour les rafraîchissements. Une telle solution de fonctionnement entrelacé présente un double inconvénient. Tout d'abord, cette solution nécessite, pour une capacité de mémorisation donnée, une mémoire deux fois plus importante, ce qui pose un problème de place et de coût. De plus, cette solution nécessite une écriture spécifique des programmes afin de gérer les adresses entrelacées.

La présente invention vise à pallier les inconvénients des solutions connues en proposant une nouvelle solution permettant de supprimer les délais d'attente liés au rafraîchissement, aux lectures ou aux écritures des mémoires dynamiques.

L'invention vise également à accélérer les accès en lecture et en écriture de données dans la mémoire.

Pour atteindre ces objets, la présente invention prévoit un circuit de mémoire dynamique comprenant une pluralité de cellules mémoire organisées en un réseau matriciel, et comprenant des commutateurs pour associer à chaque extrémité de chaque colonne du réseau matriciel, au moins deux bascules commandées indépendamment l'une de l'autre pour mémoriser des données écrites ou lues dans la colonne considérée, lesdites bascules étant regroupées en deux couples d'ensembles, chaque ensemble étant associé à un registre de stockage de l'adresse de rangée des données contenues dans cet ensemble de bascules.

Selon un mode de réalisation de la présente invention, les deux couples d'ensembles de bascules sont respectivement associés à un premier et à un deuxième couple de lignes d'entrée/sortie propres à être connectées séparément à une première et à une deuxième borne d'entrée/sortie du circuit mémoire.

Selon un mode de réalisation de la présente invention, le circuit mémoire est prévu pour que l'accès au réseau matriciel pour un ensemble de bascules s'effectue simultanément pour toutes les bascules de l'ensemble.

Selon un mode de réalisation de la présente invention, le circuit mémoire est prévu pour que l'accès aux données contenues dans un ensemble de bascules depuis l'extérieur du circuit s'effectue individuellement, chaque bascule d'un même ensemble étant sélectionnée individuellement par un signal d'adressage de colonne des cellules mémoire.

Selon un mode de réalisation de la présente invention, le circuit mémoire comporte, associé à chaque ensemble de bascules, un comparateur de l'adresse contenue dans ledit registre d'adresses correspondant, à une adresse fournie par un bus d'adresses de rangée.

Selon un mode de réalisation de la présente invention, le circuit mémoire comprend une première pluralité d'amplificateurs de lecture disposés chacun entre un premier commutateur respectif et lesdites au moins deux bascules qui lui sont associées, et une deuxième pluralité d'amplificateurs de lecture disposés chacun entre un deuxième commutateur respectif et lesdites au moins deux bascules qui lui sont associées.

Selon un mode de réalisation de la présente invention, le circuit mémoire comporte une machine d'état propre à adresser successivement les différentes rangées de la matrice.

Selon un mode de réalisation de la présente invention, les première et deuxième bornes d'entrée/sortie du circuit mémoire sont reliées l'une à l'autre.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 représente partiellement un mode de réalisation d'un circuit mémoire dynamique selon la présente invention ; et
la figure 2 représente, de façon plus détaillée, un élément de lecture de ligne de bit du circuit mémoire représenté à la figure 1.

Les mêmes éléments ont été désignés par les mêmes références dans les deux figures. Pour des raisons de clarté, seuls les éléments du circuit mémoire qui sont nécessaires à la compréhension de l'invention ont été représentés et seront décrits par la suite.

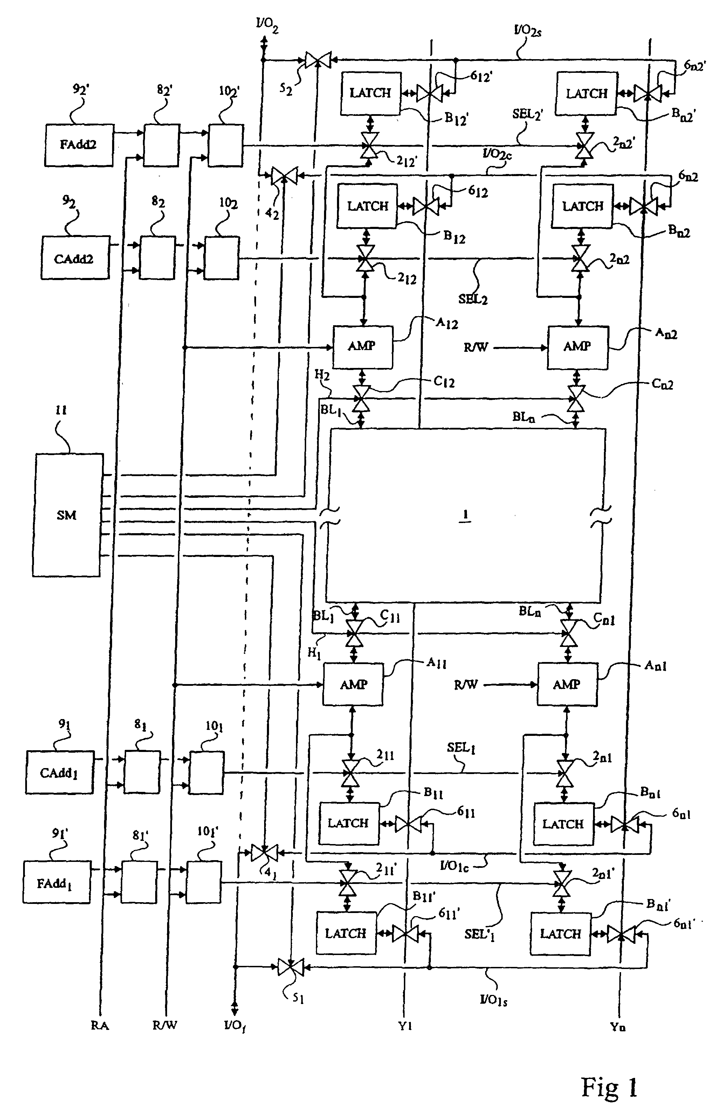

En figure 1, un circuit mémoire dynamique selon l'invention comprend, de façon classique, un réseau 1 de cellules mémoire contenant plusieurs cellules mémoire individuelles (non représentées). Chaque cellule mémoire comprend généralement un transistor et une capacité. Les cellules mémoire sont typiquement organisées en une matrice de rangées et de colonnes. Chaque cellule mémoire est couplée à une ligne de bit BL (ou colonne), comprenant généralement une paire de lignes complémentaires (une ligne de bit directe $BL_d$ et d'une ligne de bit $BL_r$ dite "ligne de bit de référence" complémentaire), et à une ligne de mot, ou rangée, (non représentée). L'état logique du signal de données présent sur la ligne de bit est déterminé par le niveau de charge du condensateur de la cellule correspondante.

Une mémoire dynamique comprend généralement plusieurs réseaux matriciels 1. Chaque réseau matriciel comprend des décodeurs de rangée (non représentés) chargés de déterminer, à partir d'une adresse de lecture ou d'écriture, la rangée du réseau matriciel ou le mot adressé. Chaque réseau est également associé à des décodeurs de colonne chargés de décoder les adresses pour déterminer la ligne de bit adressée. Chaque colonne comprend une ligne de bit BL.

Par souci de simplification, on ne considérera par la suite qu'une seule matrice de cellules mémoire ayant n colonnes (figure 1). Les éléments qui seront exposés en relation avec cette matrice 1 sont, bien entendu, reproduits sur les autres matrices éventuelles du circuit mémoire.

Selon la présente invention, chaque colonne i, i étant compris entre 1 et n, est associée à quatre bascules (LATCH) $B_{i1}$, $B_{i1}'$ et $B_{i2}$, $B_{i2}'$ de mémorisation temporaire d'une donnée lue ou à écrire.

Dans un circuit mémoire classique, des amplificateurs de lecture $A_1$, ..., $A_n$, dont le nombre correspond au nombre de lignes de bits BL du réseau 1, sont intercalés entre les lignes de bits BL et des bornes I/O d'entrée/sortie du circuit mémoire. Le cas échéant, des préamplificateurs supplémentaires sont intercalés entre les amplificateurs de lecture et ces bornes d'entrée/sortie. On notera que les amplificateurs $A_1$, ..., $A_n$ sont bidirectionnels, et servent également lors de l'écriture de données dans chaque colonne. Ils servent notamment à accélérer le fonctionnement des bascules comme le feraient des préamplificateurs d'un circuit classique.

Selon le mode de réalisation de la présente invention illustré par la figure 1, chaque extrémité de chaque ligne de bit $BL_i$ du réseau 1 est reliée à une borne d'entrée/sortie I/O ($I/O_1$ pour l'extrémité inférieure et $I/O_2$ pour l'extrémité supérieure) par un amplificateur $A_i$ ($A_{i1}$ pour l'extrémité inférieure et $A_{i2}$ pour l'extrémité supérieure). Les bornes $I/O_1$ et $I/O_2$ seront normalement confondues, comme cela a été représenté en pointillés en figure 1, ou maintenues distinctes pour constituer une mémoire à double accès. Les indices 1 et 2 apparaissant dans la figure 1 désignent respectivement les éléments reliés à la partie inférieure et à la partie supérieure d'une ligne de bit. L'amplificateur $A_i$ est relié à deux bascules $B_i$ et $B_i'$ connectées en parallèle. Ainsi, les bascules $B_i$ et $B_i'$ constituent autour du réseau 1 quatre ensembles de bascules $B_{i1}$, $B_{i1}'$, $B_{i2}$ et $B_{i2}'$. Un commutateur $C_i$ est intercalé entre l'amplificateur et la ligne de bit. Le commutateur est commandé par un signal H qui sera décrit par la suite. Un commutateur $2_i$ ou $2_i'$ est intercalé entre l'amplificateur et la bascule $B_i$ ou $B_i'$ pour permettre une sélection de la bascule devant stocker temporairement le bit associé à la colonne.

Comme on le verra par la suite, les bascules ont la même constitution que les amplificateurs de lecture, de sorte que les amplificateurs $A_i$ peuvent être omis dans certaines conditions. Les éléments de commutation $2_i$ des colonnes i sont commandés simultanément par un signal SEL qui sera décrit par la suite. De même, les éléments de commutation $2_i'$ des colonnes i sont commandés simultanément par un signal SEL' qui sera décrit par la suite.

En outre chaque bascule $B_i$ est reliée à une borne d'entrée/sortie I/O ($I/O_1$, $I/O_2$) par une ligne intermédiaire $I/O_c$ ($I/O_{1c}$, $I/O_{2c}$) et chaque bascule $B_i'$ est reliée à une borne d'entrée/sortie I/O ($I/O_1$, $I/O_2$) par une ligne intermédiaire $I/O_s$ ($I/O_{1s}$, $I/O_{2s}$). La sélection de la ligne $I/O_c$ ou $I/O_s$ devant être raccordée à la ligne I/O s'effectue au moyen d'un élément de commutation 4 ($4_1$, $4_2$) ou 5 ($5_1$, $5_2$). Les éléments de commutation 4 et 5 sont commandés par une machine d'état 11 (SM) dont le fonctionnement sera décrit par la suite.

Les bascules $B_{i1}$ sont reliées à la ligne $I/O_{1c}$ par l'intermédiaire d'éléments de commutation $6_{i1}$ commandés par un signal classique $Y_i$ de sélection de colonne. De même, les bascules $B_{i1}'$ sont reliées à la ligne $I/O_{1s}$ par l'intermédiaire d'éléments de commutation $6_{i1}'$ commandés par le signal de sélection de colonne $Y_i$. Les bascules $B_{i2}$ et $B_{i2}'$ sont reliées de façon similaire aux lignes $I/O_{2c}$ et $I/O_{2s}$ par l'intermédiaire d'éléments de commutation $6_{i2}$ et $6_{i2}'$ commandés par le signal $Y_i$. De façon classique dans le fonctionnement d'un circuit mémoire, un seul signal de sélection de colonne $Y_i$ est actif à un instant donné pour sélectionner une colonne du réseau matriciel.

On notera donc que si l'accès aux données des bascules $B_{i1}$ et $B_{i1}'$ depuis la borne d'entrée/sortie $I/O_1$ s'effectue colonne par colonne au moyen des signaux d'adressage de colonne $Y_i$, l'écriture ou la lecture des données d'un ensemble de ces bascules par les amplificateurs de lecture est simultanée pour toutes les colonnes d'une même rangée.

Selon l'invention, les quatre ensembles de bascules $B_{i1}$, $B_{i1}'$, $B_{i2}$ et $B_{i2}'$ sont destinés à être sélectionnés alternativement, chacun pour des lectures/écritures sur des rangées différentes du réseau..

Chaque signal $SEL_1$, $SEL_1'$, $SEL_2$, $SEL_2'$ est obtenu à partir d'une adresse de rangée qui est présente sur un bus RA d'adresses de rangée provenant de l'extérieur ou d'un circuit (non représenté) de génération de cette adresse pour un rafraîchissement, une écriture ou une lecture. L'adresse présente sur le bus RA est envoyée sur des premières entrées de quatre comparateurs $8_1$, $8_1'$, $8_2$, $8_2'$ respectivement associés aux ensembles de bascules $B_{i1}$, $B_{i1}'$, $B_{i2}$, $B_{i2}'$. Les deuxièmes entrées des comparateurs $8_1$, $8_1'$, $8_2$ et $8_2'$ reçoivent respectivement des adresses CAdd1, FAdd1, CAdd2, FAdd2, mémorisées dans des registres $9_1$, $9_1'$, $9_2$, $9_2'$ destinés à contenir les adresses de rangée correspondant aux données stockées temporairement dans les bascules $B_{i1}$, $B_{i1}'$, $B_{i2}$, $B_{i2}'$. L'écriture des adresses de rangée dans les registres $9_1$, $9_1'$, $9_2$, $9_2'$ est effectuée en même temps que le stockage temporaire des données correspondantes dans les bascules $B_{i1}$, $B_{i1}'$, $B_{i2}$, $B_{i2}'$. L'organisation de cette écriture d'adresses de rangée dans les registres $9_1$, $9_1'$, $9_2$, $9_2'$ est à la portée de l'homme du métier.

Les comparateurs $8_1$, $8_1'$, $8_2$ et $8_2'$ délivrent chacun un signal à deux états, indicateur du résultat de la comparaison entre l'adresse présente sur le bus RA et l'adresse mémorisée dans les registres $9_1$, $9_1'$, $9_2$ et $9_2'$. Ces signaux sont respectivement combinés par un élément logique $10_1$, $10_1'$, $10_2$, $10_2'$ avec un signal R/W indicateur d'une opération de lecture ou d'écriture pour activer ou désactiver les éléments de commutation $2_{i1}$,

$2_{i1}'$, $2_{i2}$, $2_{i2}'$. On notera que les registres 9 contiennent toujours des valeurs, qui correspondront soit à des adresses réelles, soit à des valeurs rémanentes sans signification. Un bit de validation (non représenté) produit par la machine d'état 11 sera ainsi utilisé pour valider ou invalider le contenu des registres 9.

Le circuit mémoire de l'invention nécessite, comme une mémoire classique, un rafraîchissement périodique du contenu des cellules mémoire. Pour ce faire, ce circuit est associé à un mécanisme de génération d'adresses de rafraîchissement (non représenté), par exemple, une machine d'état de rafraîchissement classique. Cette machine d'état génère des adresses de rangée internes destinées à rafraîchir les données stockées dans les cellules mémoire. Cette machine d'état de rafraîchissement délivre ses adresses à un sélecteur (non représenté) pour sélectionner une adresse de rangée parmi les adresses de rangée internes destinées au rafraîchissement et des adresses de rangée externes destinées à une lecture/écriture, par exemple sous commande d'un programme. Les adresses de rangée internes fournies par la machine d'état de rafraîchissement sont indépendantes de l'architecture de la mémoire. On veillera simplement à ce que la machine d'état de rafraîchissement fournisse toutes les adresses de rangée pendant une période de rafraîchissement.

En fonctionnement, le sélecteur (par exemple, un multiplexeur) transmet une adresse de rangée externe au moyen de décodage de rangée lors d'une opération d'écriture. Lors d'une opération de lecture, ce sélecteur transmet, soit l'adresse de rangée interne issue de la machine d'état de rafraîchissement, soit l'adresse de rangée externe. La commande en fonction de l'opération à effectuer est classique.

Selon l'invention, l'adresse de rangée courante issue du sélecteur est également envoyée sur le bus RA. La machine d'état 11 sert entre autres à fournir sur le bus RA l'adresse de rangée suivante et l'adresse de rangée précédente, et à organiser le stockage des adresses dans les registres $9_1$, $9_1'$, $9_2$ et $9_2'$. La définition de la position des adresses suivante et précédente est liée à l'organisation de la matrice et à l'utilisation qui est faite de la mémoire. Il peut par exemple s'agir d'adresses consécutives physiquement ou temporellement.

La fonction d'un signal H ($H_1$ ou $H_2$) est d'isoler la structure d'écriture/lecture correspondante formée par l'amplificateur A et les bascules B et B'. Lorsque ce signal H est activé, il est possible, à travers l'amplificateur A, de lire une donnée dans la colonne et de la stocker dans la bascule B ou B', ou bien d'écrire dans la colonne la donnée stockée dans la bascule B ou B'. Lorsque le signal H est inactivé, l'amplificateur A est isolé de la colonne.

La fonction des signaux SEL et SEL' est d'activer ou désactiver la bascule B ou B' correspondante. Lorsqu'elle est activée, la bascule B ou B' charge une donnée, par exemple provenant de l'amplificateur de lecture A. Lorsqu'elle est désactivée, la bascule B ou B' se trouve isolée de l'amplificateur de lecture A.

On suppose que le signal H1 est actif, et que le signal H2 est inactif. Seule la première structure d'écriture/lecture est sélectionnée, la seconde est isolée du réseau mémoire 1.

En lecture, lors de l'adressage d'une rangée courante au moyen du bus RA, le contenu de toute la rangée courante adressée est transféré dans le premier ensemble de bascules $B_1$. Dans cette phase, les adresses de rangée disponibles respectivement dans le registre $9_1$ et sur le bus RA sont identiques, car fixées simultanément par le même moyen. Le signal $SEL_1$ sélectionne alors le premier ensemble de bascules $B_1$. Les éléments de commutation $2_1$ sont passants, de préférence uniquement pendant la période nécessaire au stockage des données dans les bascules $B_1$, c'est-à-dire généralement une partie d'un cycle d'horloge. Par ce stockage intermédiaire, le décodeur de rangées et les amplificateurs de lecture $A_1$ sont disponibles et peuvent être utilisés à d'autres fins, par exemple pour rafraîchir le réseau mémoire pendant la lecture par rangée, colonne après colonne (autrement dit, par page), des données contenues dans le premier ensemble de bascules.

De plus, dès que les données de la rangée courante ont été transférées vers les bascules $B_1$, la machine d'état 11 peut générer, sur le bus RA, l'adresse suivante de rangée dans le réseau mémoire 1. Cet adressage en lecture provoque la copie du contenu des cellules mémoire de cette rangée suivante dans le deuxième ensemble de bascules $B_1'$, l'adresse $FAdd_1$ du registre $9_1'$ étant alors identique à l'adresse de rangée présentée sur le bus RA.

De même, dès que les données de la rangée suivante ont été transférées vers les bascules $B_1'$, la machine d'état 11 peut désactiver H1, activer H2 et générer sur le bus RA l'adresse précédente de rangée dans le réseau mémoire 1. Cet adressage en lecture provoque la copie du contenu des cellules mémoire de cette rangée précédente dans le premier ensemble de bascules $B_2$, l'adresse $CAdd_2$ du registre $9_2$ étant alors identique à l'adresse de rangée présente sur le bus RA.

Pendant la lecture par page des données de la première rangée stockées dans l'ensemble de bascules $B_1$, les éléments de commutation $2_1$ sont bloqués de manière à isoler les bascules $B_1$ des amplificateurs de lecture. Les éléments de commutation $4_1$ sont passants pour affecter la ligne d'entrée/sortie $I/O_c$ à la borne d'entrée/sortie I/O. Les éléments de commutation $6_1$ des différentes colonnes i sont successivement rendus passants par la sélection de colonne opérée par les signaux Yi. Pendant cette période de lecture de la rangée, les éléments de commutation $5_1$, $4_2$ et $5_2$ sont bloqués de manière à isoler les sorties des bascules des ensembles $B_1'$, $B_2$ et $B_2'$ des bornes d'entrée/sortie $I/O_1$ et $I/O_2$ du circuit mémoire.

Lors de la copie des données de la rangée suivante dans les bascules $B_1'$, les éléments de commutation $2_1'$ sont passants uniquement pendant la période nécessaire à ce stockage, c'est-à-dire généralement une partie d'un cycle d'horloge. De même, lors de la copie des données de la rangée précédente dans les bascules $B_2$, les éléments de commutation $2_2$ sont passants uniquement pendant la période nécessaire.

L'information contenue dans les ensembles de bascules $B_1'$ et B2 est, par conséquent, immédiatement disponible dès que la rangée correspondante est adressée. L'ensemble de bascules $B_1'$ ou $B_2$ devient automatiquement l'ensemble de bascules courantes et les ensemble de bascules $B_1$ et $B_2'$ deviennent alors les ensembles de bascules destinées à stocker les données des rangées suivante et précédente.

Si l'adresse externe suivante ne correspond pas aux adresses de rangée stockées dans les registre $9_1'$ et $9_2$, la lecture s'effectue de façon classique par l'adressage de rangées de cellules mémoire et, dans ce cas, la présence des registres n'apporte aucun gain de temps.

Si l'adresse externe de lecture suivante correspond à l'adresse stockée dans le registre $9_1'$ ou $9_2$, la concordance des adresses est automatiquement détectée au moyen du comparateur $8_1'$ ou $8_2$ et permet l'accès immédiat aux données contenues dans l'ensemble de bascules $B_1'$ ou $B_2$ qui sont alors lues par page, comme pour la première lecture.

On remarquera qu'une opération de lecture dans une bascule B ne demande pas, comme une opération de lecture dans une colonne, de charger de longues pistes métalliques telles que les lignes de bit, et qu'elle est donc notablement plus rapide. Selon la présente invention, on réalise un gain de temps considérable en copiant, en un seul accès au réseau mémoire, les données d'une rangée dans un ensemble de registres, puis en lisant très rapidement les données dans chaque registre de l'ensemble, plutôt que d'effectuer selon l'état de la technique autant d'accès au réseau mémoire que l'on veut faire de lectures.

On se place à nouveau dans le cas d'opérations de lecture, la première structure d'écriture/lecture ($A_{i1}$, $B_{i1}$, $B_{i1}'$) étant sélectionnée par le signal H1. Lors de la sélection des bascules $B_1$ (ou $B_1'$) par l'intermédiaire du signal $SEL_1$ (ou $SEL_1'$), les données sont stockées dans les bascules correspondantes en étant fournies par l'amplificateur de lecture.

La machine d'état 11 est prévue pour que le signal $SEL_1$ ou $SEL_1'$ ne reste pas dans l'état de sélection plus d'un ou quelques cycles d'horloge. Par conséquent, l'amplificateur de lecture de la structure sélectionnée est isolé de la bascule $B_1$ ou $B_1'$ considérée. Pendant la lecture par page de la copie des données stockées dans les bascules $B_1$ ou $B_1'$, on peut démarrer une phase de rafraîchissement grâce à la machine d'état de rafraîchissement, ou sélectionner la deuxième structure d'écriture/lecture ($A_{i2}$, $B_{i2}$, $B_{i2}'$) pour stocker des données dans les bascules $B_2$ ou $B_2'$. Lors d'une phase de rafraîchissement, les adresses de rangée précédemment disponibles sur les décodeurs de rangées sont remplacées par des adresses de rangée générées en interne par la machine d'état de rafraîchissement. Les adresses de rangée externes restent bien entendu dans le registre d'adresses $9_1$, $9_1'$, $9_2$ ou $9_2'$ en cas d'opération d'écriture. La machine d'état de rafraîchissement produit ainsi les différentes adresses de rangée pour synchroniser les accès destinés au rafraîchissement.

Pendant une opération d'écriture, si l'adresse de la rangée dans laquelle on veut écrire n'est pas contenue dans un des registres $9_1$, $9_1'$, $9_2$ ou $9_2'$, l'opération est une opération d'écriture classique et l'adresse doit être présente dans le décodeur de rangées de manière à permettre le stockage des nouvelles données dans les cellules mémoire concernées. La machine d'état de rafraîchissement, de même que la machine d'état 11 de commande des ensembles de bascules B et B', sont désactivées pendant ces phases d'écriture classiques.

Si par contre l'adresse de la rangée dans laquelle on veut écrire est contenue dans un des registres $9_1$, $9_1'$, $9_2$ ou $9_2'$, alors il est possible de stocker les nouvelles données dans l'ensemble de bascules $B_1$, $B_1'$, $B_2$, $B_2'$ correspondant à la rangée désirée, puis d'écrire en une seule fois le contenu de cet ensemble de bascules dans la rangée désirée du réseau mémoire 1. On notera que cette opération d'écriture de rangée s'effectue en parallèle sur toutes les colonnes du réseau mémoire 1, et qu'elle ne prend pas plus de temps qu'une opération classique d'écriture dans une seule colonne. D'autre part, une opération d'écriture dans une bascule B ne demande pas, comme une opération d'écriture dans une colonne, de charger de longues pistes métalliques, telles que les lignes de bit, et elle est donc notablement plus rapide.

Selon la présente invention, on réalise un gain de temps considérable en effectuant très rapidement des écritures dans un ensemble de registres correspondant à une rangée, puis en écrivant la rangée en un seul accès différé au réseau mémoire, plutôt que d'effectuer selon l'état de la technique autant d'accès au réseau mémoire que l'on veut faire d'écritures.

Lorsque l'on veut réaliser une écriture dans le réseau mémoire au moyen d'un amplificateur A, ce dernier est mis en mode d'écriture, à un niveau de tension dit niveau de précharge. L'amplificateur est sélectionné à un instant prédéterminé avant l'opération d'écriture pour lui laisser le temps d'atteindre ce niveau de tension. Selon la présente invention, si un ensemble d'amplificateurs $A_1$ de l'une des structures d'écriture/lecture est sélectionné en préparation d'une écriture et est rendu indisponible pour une autre utilisation, cette structure est isolée du réseau mémoire et l'autre structure d'écriture/lecture est reliée au réseau mémoire, par exemple pour y effectuer une opération de rafraîchissement. Cette caractéristique permet à la machine d'état de rafraîchissement de travailler sans la contrainte liée à l'indisponibilité des amplificateurs avant une écriture.

Le fait de n'écrire que dans les registres et non directement dans le réseau mémoire libère les amplificateurs pour d'autres tâches comme un rafraîchissement, des écritures dans d'autres registres ou depuis d'autres registres. Cela permet d'écrire très rapidement dans un ensemble de registres, et de reporter à un instant ultérieur, c'est-à-dire lorsque les amplificateurs sont à nouveau disponibles, l'écriture des données contenues dans l'ensemble de registres dans la rangée correspondante du réseau.

Comme on l'a précédemment mentionné, on dispose en permanence de trois ensembles de registres contenant respectivement les données d'une rangée courante, d'une rangée suivante et d'une rangée précédente. Il est ainsi possible selon la présente invention d'avoir accès à tout instant à plusieurs mots stockés dans la mémoire (c'est ce que l'on appelle une profondeur de "burst" élevée). Cela permet une grande souplesse dans l'organisation et la gestion de la mémoire.

On notera qu'il est possible de prévoir un plus grand nombre d'ensembles de bascules commandés de façon circulaire, si on souhaite pouvoir stocker un plus grand nombre de rangées de cellules mémoire temporairement. Le nombre d'ensembles de bascules dépend de l'application et de la vitesse de lecture souhaitée, ainsi que d'un compromis à accepter entre l'amélioration des performances et l'accroissement de la complexité et de la surface.

On notera également que si, dans la plupart des cas, les adresses suivante et précédente sont l'adresse courante plus ou moins 1, on peut également prévoir la machine d'état 11 pour que l'adresse suivante corresponde à un écart supérieur à 1. Le choix d'un tel écart peut correspondre à des applications particulières dans lesquelles, statistiquement, les adresses consécutivement utilisées sont différentes d'un nombre supérieur à 1.

Un avantage de la présente invention est qu'en prévoyant deux structures d'écriture/lecture destinées à stocker temporairement les données lues ou devant être écrites dans la mémoire, l'opération de rafraîchissement peut intervenir pendant l'échange de données avec l'extérieur de la mémoire.

Un autre avantage de la présente invention est qu'en prévoyant plusieurs bascules de stockage temporaire par colonne, et en associant ces bascules à des registres d'adresses de rangée, il est possible d'accélérer considérablement la lecture et l'écriture de données dans le réseau mémoire. La présente invention tire profit du fait que, dans la plupart des programmes, les adresses traitées correspondent à des adresses consécutives en mémoire. De façon statistique, cela se vérifie à près de 100% pour l'adressage d'une mémoire vidéo et à environ 80% pour les autres applications. On réduit ainsi considérablement les délais d'attente liés au rafraîchissement de la mémoire et on réduit, de façon statistique, les temps d'accès à la mémoire.

Un autre avantage de la présente invention est qu'elle n'augmente que très faiblement l'encombrement du circuit mémoire. On peut considérer que l'augmentation de la taille du circuit mémoire est de l'ordre de $1/500^{\text{ème}}$, ce qui constitue un faible prix à payer pour les avantages que procure l'invention.

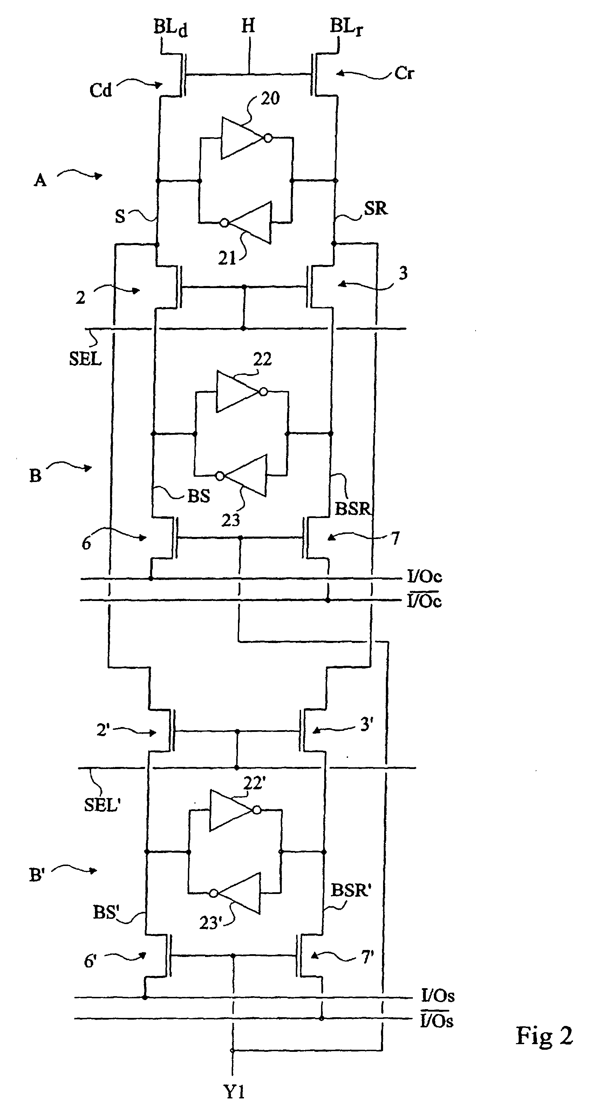

La figure 2 représente un amplificateur de lecture A relié à une extrémité d'une ligne de bit BL par l'intermédiaire d'un commutateur C, et associé à deux bascules B et B'. Une ligne de bit est composée d'une ligne de bit directe $BL_d$ et une ligne de bit $BL_r$ dite "ligne de bit de référence" complémentaire. Le commutateur C est composé d'un élément de commutation $C_d$ sur la ligne $BL_d$ et d'un élément de commutation complémentaire $C_r$ sur la ligne $BL_r$. Des éléments de commutation 3, 3', 7 et 7' traitent les signaux complémentaires des signaux traversant les éléments de commutation 2, 2', 6 et 6'. Des signaux $\overline{I/O_c}$ et $\overline{I/O_s}$ sont les signaux complémentaires des signaux $I/O_c$ et $I/O_s$ décrits en relation avec la figure 1.

Comme il ressort de la figure 2, un amplificateur de lecture A est généralement formé de deux inverseurs 20, 21 couplés en antiparallèle entre des lignes de bit complémentaires $BL_d$, $BL_r$. Selon un mode de réalisation de l'invention, chaque bascule B comprend également une paire d'inverseurs 22, 23 montés en antiparallèle entre deux lignes complémentaires BS et BSR. De même, chaque bascule B' comprend deux inverseurs 22', 23' montés en antiparallèle entre deux lignes complémentaires BS', BSR'. Ainsi, chaque bascule B, B' a une structure similaire à celle d'un amplificateur de lecture. C'est pourquoi, comme cela a été indiqué précédemment, les inverseurs 20, 21 peuvent être omis, à condition d'adapter les inverseurs des bascules B et B' pour pouvoir charger les lignes de bit.

Dans le mode de réalisation représenté en figure 2, les différents éléments de commutation sont réalisés au moyen de transistors MOS. Les transistors constitutifs des éléments de commutation $C_d$, $C_r$ ont leurs grilles reliées ensemble, celles-ci recevant le signal H susmentionné. Les transistors constitutifs des éléments de commutation 2, 3 ont leurs grilles reliées ensemble à la sortie d'un élément 10 (figure 1), ces grilles recevant un signal SEL. Ces transistors sont intercalés entre la paire d'inverseurs 20, 21 de l'amplificateur de lecture et la paire d'inverseurs 22, 23 de la bascule B. Les transistors constitutifs des éléments de commutation 6, 7 sont respectivement intercalés entre la paire d'inverseurs 22, 23 constitutive de la bascule B et les lignes $I/O_c$, $\overline{I/O_c}$. Les transistors constitutifs des éléments de commutation 2', 3' sont commandés par le signal SEL', leurs grilles respectives étant reliées à la sortie d'un élément 10'. Ces transistors sont intercalés entre la paires d'inverseurs 20, 21 de l'amplificateur de lecture et la paire d'inverseurs 22', 23' de la bascule B'. Les transistors constitutifs des éléments de commutation 6', 7' sont respectivement intercalés entre la paire d'inverseurs 22', 23' de la bascule B' et les lignes d'entrée/sortie $I/O_s$, $\overline{I/O_s}$. Les grilles des transistors constitutifs des éléments 6, 7, 6' et 7' sont toutes commandées par le signal de sélection de colonne (par exemple Y1).

Bien entendu, la présente invention est susceptible de diverses variantes et modifications qui apparaîtront à l'homme de l'art. En particulier, la réalisation pratique des machines d'état nécessaires à la commande du circuit mémoire est à la portée de l'homme du métier à partir des indications fonctionnelles données ci-dessus. De plus, d'autres éléments de commutation ou de stockage temporaire, tels que respectivement des transistors ou des inverseurs, pourront être utilisés pourvu qu'ils respectent les caractéristiques fonctionnelles exposées précédemment.

## Revendications

1.   Circuit de mémoire dynamique comprenant une pluralité de cellules mémoire organisées en un réseau matriciel, qui comprend des commutateurs ($C_1$ ; $C_2$) pour associer à chaque extrémité de chaque colonne du réseau matriciel, au moins deux bascules ($B_1$, $B_1'$ ; $B_2$, $B_2'$) commandées indépendamment l'une de l'autre, pour mémoriser des données écrites ou lues dans la colonne considérée, lesdites bascules étant regroupées en deux couples d'ensembles ($B_1$, $B_1'$ ; $B_2$, $B_2'$), chaque ensemble étant associé à un registre ($9_1$ ; $9_1'$ ; $9_2$ ; $9_2'$) de stockage de l'adresse de rangée des données contenues dans cet ensemble de bascules.

2.   Circuit mémoire selon la revendication 1, **caractérisé en ce que** les deux couples d'ensembles de bascules sont respectivement associés à un premier et à un deuxième couple de lignes d'entrée/sortie ($I/O_{1c}$, $I/O_{1s}$ ; $I/O_{2c}$, $I/O_{2s}$) propres à être connectées séparément à une première et à une deuxième borne ($I/O_1$ ; $I/O_2$) d'entrée/sortie du circuit mémoire.

3.   Circuit mémoire selon la revendication 1 ou 2, **caractérisé en ce qu'**il est prévu pour que l'accès au réseau matriciel pour un ensemble de bascules ($B_1$ ; $B_1'$ ; $B_2$ ; $B_2'$) s'effectue simultanément pour toutes les bascules de l'ensemble.

4.   Circuit mémoire selon l'une quelconque des revendications 1 à 3, **caractérisé en ce qu'**il est prévu pour que l'accès aux données contenues dans un ensemble de bascules ($B_1$ ; $B_1'$ ; $B_2$ ; $B_2'$) depuis l'extérieur du circuit s'effectue individuellement, chaque bascule d'un même ensemble étant sélectionnée individuellement par un signal d'adressage de colonne ($Y_1$, ..., $Y_n$) des cellules mémoire.

5.   Circuit mémoire selon l'une quelconque des revendications 1 à 4, **caractérisé en ce qu'**il comporte, associé à chaque ensemble de bascules ($B_1$ ; $H_1'$ ;

$B_2$ ; $B_2$'), un comparateur de l'adresse contenue dans ledit registre d'adresses correspondant, à une adresse fournie par un bus d'adresses de rangée (RA).

6. Circuit mémoire selon l'une quelconque des revendications 1 à 5, **caractérisé en ce qu'**il comprend :

une première pluralité d'amplificateurs de lecture ($A_1$) disposés chacun entre un premier commutateur respectif ($C_1$) et lesdites au moins deux bascules ($B_1$, $B_1$') qui lui sont associées, et
une deuxième pluralité d'amplificateurs de lecture ($A_2$) disposés chacun entre un deuxième commutateur respectif ($C_2$) et lesdites au moins deux bascules ($B_2$, $B_2$') qui lui sont associées.

7. Circuit mémoire selon l'une quelconque des revendications 1 à 6, **caractérisé en ce qu'**il comporte une machine d'état (11) propre à adresser successivement les différentes rangées de la matrice.

8. Circuit mémoire selon l'une quelconque des revendications 2 à 7, **caractérisé en ce que** les première et deuxième bornes d'entrée/sortie ($I/O_1$ ; $I/O_2$) du circuit mémoire sont reliées l'une à l'autre.

**Patentansprüche**

1. Dynamische Speicherschaltung (DRAM-Speicher) mit einer Mehrzahl von in einem Matrixnetz organisierten Speicherzellen, mit Schaltern (C1;C2), welche jeweils jedem Ende jeder Spalte des Matrixnetzes wenigstens zwei unabhängig voneinander gesteuerte Kippschaltungen ($B_1$ ,$B_1$'; $B_2$,$B_2$') zuordnen, um in die betrachtete Spalte geschriebene oder aus ihr gelesene Daten zu speichern, wobei die genannten Kippstufen in zwei Paare von Gruppen ($B_1$, $B_1$'; $B_2$, $B_2$') umgruppiert werden, und wobei jede Gruppe jeweils einem Register ($9_1$; $9_1$'; $9_2$; $9_2$') zur Speicherung der Zeilenadresse der in dieser Gruppe von Kippstufen enthaltenen Daten zugeordnet ist.

2. Speicherschaltung nach Anspruch 1, **dadurch gekennzeichnet, dass** die zwei Paare von Kippstufen-Gruppen jeweils entsprechend einem ersten beziehungsweise einem zweiten Paar von Eingangs-/Ausgangsleitungen ($I/O_{1c}$, $I/O_{1s}$; $I/O_{2c}$, $I/O_{2s}$) zugeordnet sind, die gesondert mit einem ersten und einem zweiten Eingangs-/Ausgangsanschluß ($I/O_1$;$I/O_2$) der Speicherschaltung verbunden werden können.

3. Speicherschaltung nach Anspruch 1 oder 2, **da-**

**durch gekennzeichnet, dass** vorgesehen ist, dass der Zugang bzw. Zugriff zu dem Matrixnetz für eine Gruppe von Kippstufen bzw. -schaltungen ( $B_1$ ; $B_1$'; $B_2$; $B_2$') für alle Kippschaltungen der Gruppe gleichzeitig erfolgt.

4. Speicherschaltung nach einem der Ansprüche 1 bis 3, **dadurch gekennzeichnet, dass** vorgesehen ist, dass der Zugriff zu den in einer Gruppe von Kippstufen ($B_1$;$B_1$';$B_2$;$B_2$') enthaltenen Daten von außerhalb der Schaltung her individuell erfolgt, und dass jeweils jede Kippstufe ein und derselben Gruppe individuell durch ein Spaltenadressierungssignal ($Y_1$, ... ,$Y_n$) ausgewählt wird.

5. Speicherschaltung nach einem der Ansprüche 1 bis 4, **dadurch gekennzeichnet, dass** sie, jeweils in Zuordnung zu jeder Gruppe von Kippstufen ($B_1$;$B_1$'; $B_2$;$B_2$') einen Komparator aufweist, der die in dem entsprechenden genannten Adressenregister enthaltene Adresse mit einer von einem Zeilenadressenbus gelieferten Adresse vergleicht.

6. Speicherschaltung nach einem der Ansprüche 1 - 5, **dadurch gekennzeichnet, dass** sie umfasst:

eine erste Vielzahl von Leseverstärkern ($A_1$), die jeweils jeder zwischen einem entsprechenden ersten Schalter ($C_1$) und den genannten ihm zugeordneten wenigstens zwei Kippstufen angeordnet sind, und
eine zweite Vielzahl von Leseverstärkern ($A_2$), die jeweils jeder zwischen einem entsprechenden zweiten Schalter ($C_2$) und den genannten ihm zugeordneten wenigstens zwei Kippstufen ($B_2$,$B_2$') angeordnet sind.

7. Speicherschaltung nach einem der Ansprüche 1 - 6, **dadurch gekennzeichnet, dass** sie eine Zustandsmaschine (11) umfasst, die aufeinanderfolgend die verschiedenen Reihen bzw. Zeilen der Matrix adressieren kann.

8. Speicherschaltung nach einem der Ansprüche 2 - 7, **dadurch gekennzeichnet, dass** die ersten und zweiten Eingangs-/Ausgangsanschlüsse ($I/O_1$; $I/O_2$) der Speicherschaltung miteinander verbunden sind.

**Claims**

1. A DRAM circuit including a plurality of memory cells organized in an array, including switches ($C_1$; $C_2$) for associating with each end of each column of the array at least two latches ($B_1$, $B_1$'; $B_2$, $B_2$') controlled independently from each other to store data written into or read from the considered column, said latches being gathered in two pairs of sets ($B_1$, $B_1'$; $B_2$, $B_2'$), each set being associated with a register ($9_1$; $9_1'$; $9_2$; $9_2'$)for storing the row address of the data contained in this latch set.

2. The memory circuit of claim 1, **characterized in that** the two pairs of sets of latches are respectively associated with a first and a second pair of input/output lines ($I/O_{1c}$, $I/O_{1s}$; $I/O_{2c}$, $I/O_{2s}$) adapted to being separately connected to a first and to a second input/output terminal ($I/O_1$; $I/O_2$) of the memory circuit.

3. The memory circuit of claim 1 or 2, **characterized in that** the access to the array for a latch set ($B_1$; $B_1'$; $B_2$; $B_2'$) is performed simultaneously for all latches in the set.

4. The memory circuit of any of claims 1 to 3, **characterized in that** the access to the data contained in a latch set ($B_1$; $B_1'$; $B_2$; $B_2'$) from outside the circuit is performed individually, each latch in a same set being individually selected by a memory cell column addressing signal ($Y_1$, ..., $Y_n$).

5. The memory circuit of any of claims 1 to 4, **characterized in that** it includes, associated with each latch set ($B_1$; $B_1'$; $B_2$; $B_2'$), a comparator of the address contained in the associated address register, with an address provided by a row address bus (RA).

6. The memory circuit of any of claims 1 to 5, **characterized in that** it includes:

   a first plurality of read amplifiers ($A_1$) each arranged between a first respective switch ($C_1$) and said at least two latches ($B_1$, $B_1'$) associated therewith, and
   a second plurality of read amplifiers ($A_2$) each arranged between a second respective switch ($C_2$) and said at least two latches ($B_2$, $B_2'$) associated therewith.

7. The memory circuit of any of claims 1 to 6, **characterized in that** it includes a state machine (11) adapted to successively address the different rows of the array.

8. The memory circuit of any of claims 2 to 7, **characterized in that** the first and second input/output terminals ($I/O_1$; $I/O_2$) of the memory circuit are interconnected.

Fig 1

Fig 2